# EUROPEAN PATENT APPLICATION

(11) **EP 4 432 514 A2**
(43) Date of publication of application: **18.09.2024**
(21) Application number: 24163749.5
(22) Date of filing: 15.03.2024
(51) Int. Cl.: H02J 7/00, G06F 11/07, G06F 1/24

(54) **SIGNAL LATCHING CIRCUIT AND METHOD, BATTERY MANAGEMENT SYSTEM, AND BATTERY SYSTEM**

(30) Priority: 16.03.2023 CN 202310256770
(71) Applicant: Xiamen Ampack Technology Limited, Xiamen City, Fujian Province 361000 (CN)
(72) Inventor: LIU, Qifan, Xiamen City, Fujian Province 361000 (CN); DU, Xiaojia, Xiamen City, Fujian Province 361000 (CN); SU, Zhigao, Xiamen City, Fujian Province 361000 (CN)
(74) Representative: Icosa

(57) **Abstract**

A signal latching circuit includes a controller, a latch, and a first reset apparatus. The controller is electrically connected to both the latch and the first reset apparatus, and the latch is configured to be electrically connected to a switch on a charging path and/or a discharging path. The controller is configured to transmit a first signal to the latch and transmit a second signal to the first reset apparatus, where the first signal is used to control the switch to turn on, and the second signal is used to indicate that the controller is in a working state. The first reset apparatus is configured to transmit a first reset signal to the controller in response to not receiving the second signal within a first duration. The latch is configured to latch the first signal during a reset period of the controller.

## Description

### TECHNICAL FIELD

This application pertains to the field of electronic circuits, and in particular, relates to a signal latching circuit and method, a battery management system, and a battery system.

### BACKGROUND

With the development of integrated circuits, controllers such as MCUs (Micro Controller Units, micro controller units) are widely applied to such as battery management systems (Battery Management Systems, BMSs). Due to external interference or other reasons, a micro controller unit often encounters program runaway, which causes the micro controller unit not to work normally. Currently, when a micro controller unit is abnormal, a BMS directly cuts off a charging path and/or a discharging path of a battery, which affects normal charging and discharging of the battery, leading to poor system stability of the BMS and a negative user experience.

### SUMMARY

In view of this, the purpose of this application is to provide a signal latching circuit and method, a battery management system, and a battery system to solve the problems of relatively poor stability and user experience of existing systems.

Embodiments of this application are implemented as follows.

According to a first aspect, an embodiment of this application provides a signal latching circuit, including a controller, a latch, and a first reset apparatus. The controller is electrically connected to both the latch and the first reset apparatus, and the latch is configured to be electrically connected to a switch on a charging path and/or a discharging path. The controller is configured to transmit a first signal to the latch and transmit a second signal to the first reset apparatus. The first signal is used to control the switch to turn on, and the second signal is used to indicate that the controller is in a working state. The first reset apparatus is configured to transmit a first reset signal to the controller in response to not receiving the second signal within a first duration. The latch is configured to latch the first signal during a reset period of the controller.

In the embodiments of this application, the first signal used to control the switch to turn on is latched using the latch, so that it remains unchanged during the reset period of the controller. In this way, when the controller is abnormal, the charging path and/or the discharging path of a battery are not directly cut off, which has no influence on normal charging and discharging of the battery, thereby solving the problems of relatively poor system stability and user experience of an existing BMS. In addition, if the first reset apparatus receives no second signal within the first duration, it transmits the first reset signal to the controller to make the controller reset to a normal state, thereby guaranteeing stable running of the system.

In one possible implementation of the embodiments of the first aspect, the first reset apparatus is a first watchdog.

In this embodiment of this application, the watchdog is selected to transmit a first reset signal to the controller, which can reduce costs and solution complexity while achieving the purpose of this invention, thereby helping improve applicability of the solution.

In one possible implementation of the embodiments of the first aspect, a second reset apparatus is further included. The second reset apparatus is electrically connected to both the controller and the latch, and the second reset apparatus is configured to transmit a second reset signal to the latch to control the switch to turn off in response to not receiving the second signal within a second duration. The second duration is greater than the first duration.

In this embodiment of this application, the latch is reset using the second reset apparatus to control the switch to turn off. This reduces safety risks such as overcharge, overdischarge, and short circuit of the battery caused by loss of effective protection for the battery due to the switch on the charging path and/or the discharging path of the battery being always on when the controller is permanently abnormal.

In one possible implementation of the embodiments of the first aspect, the second duration is less than a duration threshold. The duration threshold is configured such that within the duration threshold, the controller is in an abnormal state after receiving the first reset signal.

In this embodiment of this application, an upper limit is set for the second duration, that is, the second duration is less than the duration threshold, so that the system can run safely and reliably. This prevents safety risks caused by the switch on the charging path and/or the discharging path of the battery being on for a long time and unable to be turned off due to an excessive long second duration.

In one possible implementation of the embodiments of the first aspect, the second reset apparatus is a second watchdog.

In this embodiment of this application, the watchdog is selected to transmit a first reset signal to the controller, which can reduce the costs and the solution complexity while achieving the purpose of this invention, thereby helping improve the applicability of the solution.

According to a second aspect, an embodiment of this application further provides a signal latching circuit, including a controller, a latch, and a second reset apparatus. The controller is electrically connected to both the latch and the second reset apparatus, the second reset apparatus is further electrically connected to the latch, and the latch is configured to be electrically connected to a switch on a charging path and/or a discharging path. The controller is configured to transmit a first signal to the latch and transmit a second signal to the second reset apparatus. The first signal is used to control the switch to turn on, and the second signal is used to indicate that the controller is in a working state. The latch is configured to latch the first signal during a reset period of the controller. The second reset apparatus is configured to transmit a second reset signal to the latch to control the switch to turn off in response to not receiving the second signal from the controller within a second duration.

According to a third aspect, an embodiment of this application further provides a battery management system, including a charging switch, a discharging switch, and the foregoing signal latching circuit. The latch is electrically connected to the charging switch and/or the discharging switch.

In one possible implementation of the embodiments of the third aspect, a switch driving circuit is further included. The latch is electrically connected to an input terminal of the switch driving circuit, and an output terminal of the switch driving circuit is electrically connected to the charging switch and/or the discharging switch.

According to a fourth aspect, an embodiment of this application further provides a battery system, including a battery and the foregoing battery management system. The battery is electrically connected to the battery management system, and the battery management system is configured to control charging and/or discharging of the battery.

According to a fifth aspect, an embodiment of this application further provides an electric device, including a load and the foregoing battery system. The battery system supplies power to the load.

According to a sixth aspect, an embodiment of this application further provides a signal latching method applied to the foregoing signal latching circuit, including: transmitting, by the first reset apparatus, a first reset signal to the controller in response to not receiving the second signal from the controller within the first duration; and latching, by the latch, the first signal during the reset period of the controller, The first signal is used to control the switch to remain on during the reset period of the controller.

With reference to one possible implementation of the embodiments of the sixth aspect further includes: transmitting, by the second reset apparatus, the second reset signal to the latch in response to not receiving the second signal from the controller within the second duration.

According to a seventh aspect, an embodiment of this application further provides a signal latching method applied to the foregoing signal latching circuit, including: transmitting, by the second reset apparatus, the second reset signal to the latch in response to not receiving the second signal from the controller within the second duration; and clearing, by the latch in response to the second reset signal, the first signal latched by the latch, where the first signal is used to control the switch to remain on during a reset period of the controller.

### BRIEF DESCRIPTION OF DRAWINGS

To describe the technical solutions in some embodiments of this application and in the prior art more clearly, the following briefly describes the accompanying drawings required for describing some embodiments. Apparently, the accompanying drawings in the following description show merely some embodiments of this application, and persons of ordinary skill in the art may still derive other drawings from these accompanying drawings without creative efforts. With the accompanying drawings provided, the foregoing and other objects, features, and advantages of this application are more clear.
FIG. 1 is a schematic principle diagram of a first signal latching circuit connected to a switch s according to an embodiment of this application.
FIG. 2 is a schematic principle diagram of a second signal latching circuit connected to a switch s according to an embodiment of this application.
FIG. 3 is a schematic principle diagram of a third signal latching circuit connected to a switch s according to an embodiment of this application.
FIG. 4 is a schematic structural diagram of a battery management system according to an embodiment of this application.
FIG. 5 is a schematic flowchart of a first signal latching method according to an embodiment of this application.
FIG. 6 is a schematic flowchart of a second signal latching method according to an embodiment of this application.

### DESCRIPTION OF EMBODIMENTS

The following describes in detail some embodiments of technical solutions of this application with reference to the accompanying drawings. Apparently, the described embodiments are merely some but not all of the embodiments of this application. The following embodiments may be used as examples for a clearer description of the technical solutions of this application, which do not constitute any limitations on the protection scope of this application. Persons skilled in the art can understand that in absence of conflicts, the following embodiments and features in these embodiments may be combined.

The term "and/or" in this application is only an associative relationship for describing associated objects, indicating that three relationships may be present. For example, A and/or B may indicate three cases: presence of only A; presence of both A and B; and presence of only B.

In the description of some embodiments of this application, unless otherwise specified and defined explicitly, the technical term "electrical connection" may refer to a direct electrical connection or an indirect electrical connection via an intermediate medium. Persons of ordinary skill in the art can understand specific meanings of these terms in this application as appropriate to specific situations.

When an existing controller is abnormal, for example, the controller is accidentally abnormal due to program runaway, the controller directly cuts off a charging path and/or a discharging path of a battery, which may affect normal charging and/or discharging of the battery, affecting user experience. To solve this problem, some embodiments of this application provide a signal latching circuit. When a controller is abnormal, the signal latching circuit can latch a first signal used to control a switch on a charging path and/or a discharging path of a battery to turn on, so that the first signal remains unchanged during a reset period of the controller. In this way, when the controller is abnormal, the charging path and/or the discharging path of the battery are not directly cut off, which has no influence on normal charging and/or discharging of the battery, thereby improving user experience.

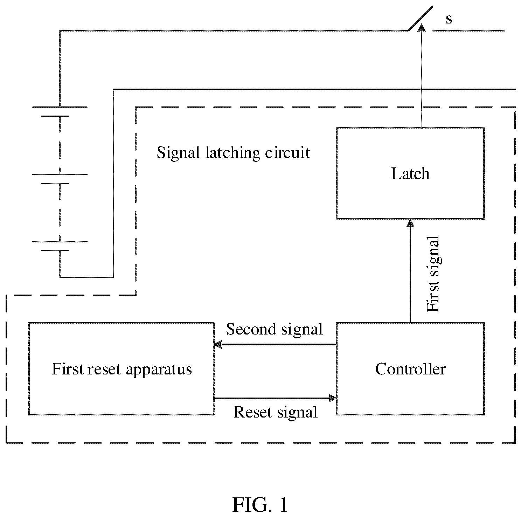

For better understanding of the solution, a signal latching circuit shown in FIG. 1 is used for illustration. The signal latching circuit includes a controller, a latch, and a first reset apparatus. The controller is electrically connected to both the latch and the first reset apparatus, and the latch is configured to be electrically connected to a switch on a charging path and/or a discharging path. The switch may be a controllable switch that can be on or off after receiving a control signal, for example, a relay, a transistor switch, an IGBT, or the like.

A switch s in FIG. 1 may be a switch on the charging path and/or the discharging path. In some embodiments, a switch on the charging path and a switch on the discharging path may be the same switch. In some other embodiments, a switch on the charging path and a switch on the discharging path may be different switches.

The controller is configured to transmit a first signal to the latch and transmit a second signal to the first reset apparatus. When the controller is in a normal working state, it transmits a first signal to the latch and transmits a second signal to the first reset apparatus. When the controller is abnormal, it stops transmitting the second signal to the first reset apparatus; or although it transmits a signal, the signal no longer follows a timing control logic of the second signal, which can be understood as that the transmitted signal is no longer the second signal. Similarly, when the controller is abnormal, it stops transmitting the first signal to the latch; or a signal transmitted to the latch no longer follows a timing control logic of the first signal, which can be understood as that the transmitted signal is no longer the first signal.

The controller may be an integrated circuit chip with a signal processing capability. The foregoing controller may be a general-purpose processor, including a central processing unit (Central Processing Unit, CPU), a network processor (Network Processor, NP), or the like. Alternatively, it may be a digital signal processor (Digital Signal Processor, DSP), an application specific integrated circuit (Application Specific Integrated Circuit, ASIC), a field-programmable gate array (Field Programmable Gate Array, FPGA) or another programmable logic device, a discrete gate or transistor logic device, or a discrete hardware component. The methods, steps, and logical block diagrams disclosed in the embodiments of this application can be implemented or performed. The general-purpose processor may be a micro controller unit (Micro Controller Unit, MCU) or any regular processor.

It can be understood that in some embodiments, the first signal may be a high-level signal that can control the switch on the charging path and/or the discharging path of the battery to turn on. In some other embodiments, the first signal may be a low-level signal that can control the switch on the charging path and/or the discharging path of the battery to turn on. Similarly, in some embodiments, the second signal may be a high-level signal that can be used to indicate that the controller is in a working state. In some other embodiments, the second signal may be a low-level signal that can be used to indicate that the controller is in a working state.

The first reset apparatus is configured to transmit a first reset signal to the controller in response to not receiving the second signal within a first duration. After receiving the first reset signal, the controller resets, and after resetting, the controller can recover from an abnormity caused by accidental program runaway. When the controller recovers to a normal state, it transmits the second signal to the first reset apparatus and transmits the first signal to the latch again.

It can be understood that in some embodiments, any one of the following situations can be considered as that the first reset apparatus receives the second signal within the first duration:
(i) The first reset apparatus receives no signal for a time exceeding the first duration. In this case, it can be considered that the controller does not to transmit any signal to the first reset apparatus, and therefore, the first reset apparatus cannot receive the second signal within the first duration.
(ii) The first reset apparatus does not receive the second signal for a time exceeding the first duration. In this case, although the first reset apparatus can receive a signal from the controller, the signal is no longer the second signal.

In some embodiments, the first reset apparatus may be a first watchdog. The first watchdog starts upon power-on, and the controller can implement a dog feeding function through a level change of an IO (Input Output, input/output) pin. Once the controller is abnormal and a dog feeding timeout period is equal to the first duration, the first watchdog generates a first reset signal to make the controller reset.

In still some other embodiments, the first reset apparatus may be an apparatus such as a micro controller unit, and is configured to transmit a first reset signal to the controller when not receiving the second signal from the controller within the first duration.

The latch is configured to latch the first signal during a reset period of the controller, so that the first signal remains unchanged during the reset period of the controller. In this way, even when the controller is abnormal, a control logic of the switch on the charging path and/or the discharging path of the battery does not change, for example, the switch is not controlled to turn off.

The latch may be any device with a signal latching function, for example, it may be an SR (Set Reset) latch or a D (Data) latch.

When a controller is permanently abnormal, for example, the controller cannot recover to a normal working state after resetting, a permanent abnormity may be considered to occur. In this case, a first reset apparatus transmits first reset signals to the controller repeatedly, and the controller is always in a resetting state. This causes a switch on a charging path and/or a discharging path of a battery to be always on and cannot be turned off, thus losing effective protection for the battery, and therefore, the battery may have safety risks such as overcharge, overdischarge, and short circuit.

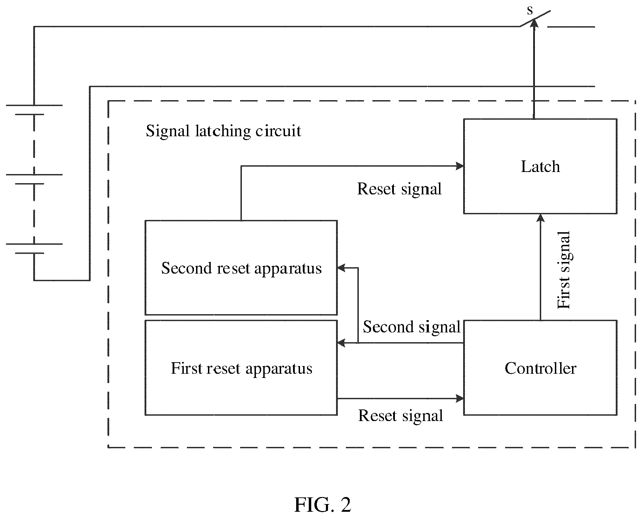

To solve this problem, in some embodiments, a signal latching circuit further includes a second reset apparatus. As shown in FIG. 2, the second reset apparatus is electrically connected to both a controller and a latch.

The second reset apparatus is configured to transmit a second reset signal to the latch to control a switch to turn off in response to not receiving the second signal within a second duration. When the controller is permanently abnormal and the abnormity duration exceeds the second duration, the second reset apparatus controls the latch to reset, so as to control a switch on a charging path and/or a discharging path of a battery to turn off, thereby protecting the battery, reducing a probability of overcharge and/or overdischarge, and reducing safety risks of short circuit and the like.

In this embodiment, when the controller is in a normal working state, it further transmits a second signal to the second reset apparatus. When the controller is abnormal, it stops transmitting the second signal to the second reset apparatus; or although it transmits a signal, the transmitted signal no longer follows timing control logic of the second signal, which can be understood as that the transmitted signal is no longer the second signal.

It can be understood that in some embodiments, any one of the following situations can be considered as that the second reset apparatus receives no second signal within the second duration:
(i) The second reset apparatus receives no signal for a time exceeding the second duration. In this case, it can be considered that the controller transmits no signal to the second reset apparatus, and therefore, the second reset apparatus cannot receive the second signal within the second duration.
(ii) The second reset apparatus does not receive the second signal for a time exceeding the second duration. In this case, although the second reset apparatus can receive a signal from the controller, the signal is no longer the second signal.

The second duration is greater than the first duration. For example, the first duration is t, and its value can be configured to such as 5s; and the second duration is n × t, where n may be any number greater than or equal to 2, and the second duration is less than a duration threshold. The duration threshold is configured such that within the duration threshold, the controller is in an abnormal state after receiving a first reset signal. In some embodiments, the duration threshold may be a safe runaway duration of a battery management system where the signal latching circuit is located. The safety runaway duration refers to a period during which the battery management system has safety failure due to a long-time resetting state of the controller. The duration may be determined in advance based on a test, that is, n × t should not be too large, and the safety runaway duration must be acceptable for the system, during which the battery encounters no safety failure.

In some embodiments, the second reset apparatus may be a second watchdog. The second watchdog starts upon power-on, and the controller can implement a dog feeding function through a level change of an IO (Input Output, input/output) pin. Once the controller is abnormal and a dog feeding timeout period is equal to the second duration, the second watchdog transmits a second reset signal to the latch to control the switch to turn off.

In still some other embodiments, the second reset apparatus may be an apparatus such as a micro controller unit, and is configured to transmit a second reset signal to the latch when not receiving the second signal from the controller within the second duration.

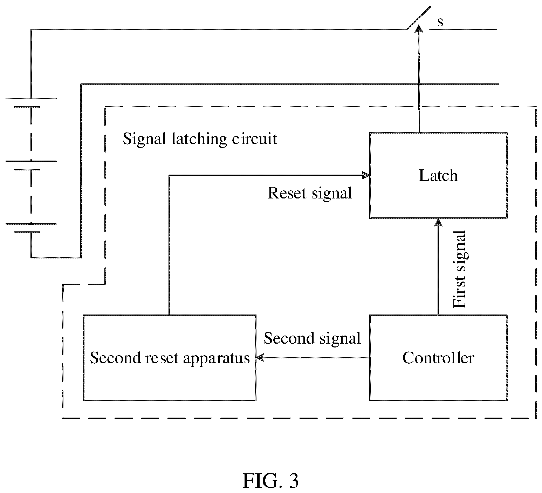

It can be understood that the foregoing first reset apparatus and second reset apparatus may not coexist. In one possible implementation, the signal latching circuit may only include the controller, the latch, and the second reset apparatus. FIG. 3 is a schematic diagram. In this way, safety risks can be reduced, such as overcharge, overdischarge, and short circuit of a battery caused by loss of effective protection for the battery due to a switch on a charging path and/or a discharging path of the battery being always on when the controller is permanently abnormal.

Some embodiments of this application further provide a battery management system (Battery Management System, BMS). The battery management system includes a charging switch, a discharging switch, and the foregoing signal latching circuit. The charging switch is located on a charging path of a battery, and the discharging switch is located on a discharging path of the battery. A latch is electrically connected to the charging switch and/or the discharging switch, and charging and discharging of the battery are managed by controlling the charging switch and/or the discharging switch to turn on or off. For example, when the charging switch is closed, the battery can be charged; and when the discharging switch is closed, the battery can be discharged. The foregoing charging switch and/or discharging switch may be a controllable switch that can be on or off after receiving a control signal, for example, a relay, a transistor switch, an IGBT, or the like.

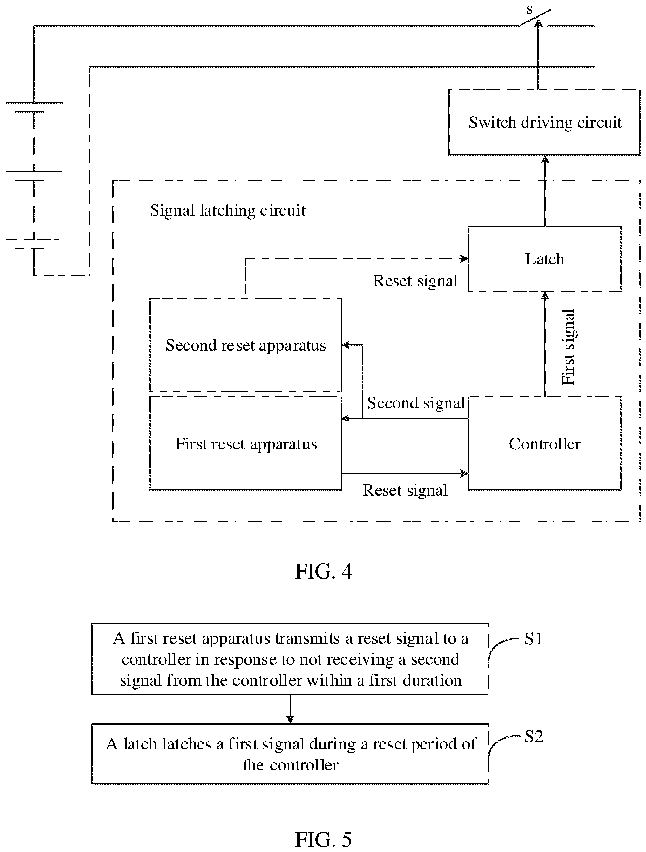

In some embodiments, as shown in FIG. 4, the battery management system further includes a switch driving circuit. A latch is electrically connected to an input terminal of the switch driving circuit, and an output terminal of the switch driving circuit is electrically connected to the charging switch and/or the discharging switch. The latch is electrically connected to the charging switch and/or the discharging switch through the switch driving circuit.

It can be understood that FIG. 4 is only one of many embodiments of this application and FIG. 4 only shows a situation where the charging switch and the discharging switch are the same switch. In some other embodiments, the charging switch and the discharging switch may be different switches.

The switch driving circuit can convert, according to requirements of a control object, a first signal used to control the charging switch and/or the discharging switch, so that a corresponding switch can be driven to turn on or off.

Different types of switches may correspond to different switch driving circuits. For example, when the foregoing charging switch and/or discharging switch is a relay, the switch driving circuit may be a relay driving circuit correspondingly. When the foregoing charging switch and/or discharging switch is a transistor switch, the switch driving circuit may be a transistor driving circuit correspondingly.

Generally, a battery energy storage system and another electric device (electrical energy supplied by a battery) are configured with a BMS. The BMS and the battery form a battery system, and the BMS is configured to manage various parameters (voltage, current, temperature, and the like) of the battery.

Principles and technical effects of the signal latching circuit according to the battery management system embodiments are the same as those of the foregoing signal latching circuit embodiments. Refer to corresponding content of the foregoing signal latching circuit embodiments for what is not mentioned in the battery management system embodiments.

Some embodiments of this application further provide a battery system. The battery system includes a battery and the foregoing battery management system, where the battery management system is electrically connected to the battery and the battery management system is configured to control charging and/or discharging of the battery.

Currently, from a perspective of market development, application of batteries is being more extensive. Batteries have been not only used in energy storage power source systems such as hydroelectric power plants, thermal power plants, wind power plants, and solar power plants, but also widely used in many other fields including electric transportation tools such as electric bicycles, electric motorcycles, and electric vehicles, military equipment, and aerospace. With the continuous expansion of application fields of traction batteries, market demands for traction batteries are also increasing.

When applied, a battery needs to be charged and discharged, and working of a battery may be controlled by a battery management system. The battery may be any battery that can provide power. For example, it may be, but is not limited to, a lithium iron phosphate battery, a ternary lithium battery, a sodium-ion battery, a magnesium-ion battery, or the like,

Principles and technical effects of the battery management system according to the battery system embodiments are the same as those of the foregoing battery management system embodiments. Refer to corresponding content of the foregoing battery management system embodiments for what is not mentioned in the battery system embodiments.

Some embodiments of this application further provide an electric device. The electric device includes a load and the foregoing battery system, where the battery system is configured to supply power to the load. Different electric devices correspond to different loads.

The electric device may be a battery energy storage system, an electric train, an electric vehicle, a ship, an electric two-wheeler (such as a battery cart and an electric bicycle), an electric motorcycle, an electric tricycle, or the like.

Principles and technical effects of the battery system according to the electric device embodiments are the same as those of the foregoing battery system embodiments. Refer to corresponding content of the foregoing battery system embodiments for what is not mentioned in the electric device embodiments.

Some embodiments of this application further provide a signal latching method. The signal latching method may be applied to the signal latching circuit shown in FIG. 1 or FIG. 2. The signal latching method provided in some embodiments of this application is described below with reference to FIG. 5.

S 1: A first reset apparatus transmits a first reset signal to a controller in response to not receiving a second signal from the controller within a first duration.

When the controller is in a normal working state, it transmits a first signal to a latch and transmits a second signal to the first reset apparatus. When the controller encounters an accidental program abnormity, it stops transmitting the second signal to the first reset apparatus. When the first reset apparatus receives no second signal from the controller within the first duration, it transmits a first reset signal to the controller to make the controller reset.

S2: The latch latches a first signal during a reset period of the controller.

To prevent the controller from directly cutting off a charging path and/or a discharging path of a battery when the controller is abnormal, in this embodiment of this application, the first signal is latched using the latch to keep the first signal unchanged during the reset period of the controller, that is, to control a switch on the charging path and/or the discharging path of the battery to remain on during the reset period of the controller.

When the signal latching method is applied to the signal latching circuit shown in FIG. 2, that is, when the signal latching circuit further includes a second reset apparatus, the signal latching method further includes: transmitting, by the second reset apparatus, a second reset signal to the latch in response to not receiving the second signal from the controller within a second duration.

When the latching circuit further includes a second reset apparatus, and the controller is in a normal working state, the controller further transmits a second signal to the second reset apparatus. If the second reset apparatus does not receive the second signal from the controller within a second duration, it transmits a second reset signal to the latch to clear the first signal latched by the latch, so as to control a switch on a charging path and/or a discharging path of a battery to turn off, thereby protecting the battery, reducing a probability of overcharge and/or overdischarge, and reducing risks of short circuit and the like.

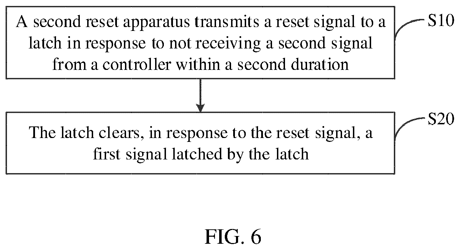

Some embodiments of this application further provide a signal latching method. The signal latching method may be applied to the signal latching circuit shown in FIG. 3. The signal latching method provided in some embodiments of this application is described below with reference to FIG. 6.

S10: The second reset apparatus transmits a second reset signal to the latch in response to not receiving a second signal from the controller within a second duration.

In this way, safety risks can be prevented, such as overcharge, overdischarge, and short circuit of a battery caused by loss of effective protection for the battery due to a switch on a charging path and/or a discharging path of the battery being always on when the controller is permanently abnormal. In this embodiment of this application, if the second reset apparatus receives no second signal from the controller within the second duration, it transmits the second reset signal to the latch to clear the first signal latched by the latch, thereby controlling the switch on the charging path and/or the discharging path of the battery to turn off.

S20: The latch clears, in response to the second reset signal, the first signal latched by the latch.

To prevent the switch on the charging path and/or the discharging path of the battery from being always on when the controller is abnormal, a second reset signal is transmitted to the latch, so that the latch clears, in response to the second reset signal, the first signal latched by the latch, thereby controlling the switch on the charging path and/or the discharging path of the battery to turn off.

Principles and technical effects of the signal latching method according to this embodiment of this application are the same as those of the foregoing signal latching circuit embodiments. Refer to corresponding content of the foregoing signal latching circuit embodiments for what is not mentioned in the signal latching method embodiments.

It should be noted that various embodiments in this specification are described in a progressive manner, each embodiment focuses on the difference from other embodiments, and the same and similar parts between various embodiments may refer to each other.

In addition, each functional module in each embodiment of this application may be integrated into an independent part, each module may exist independently, or two or more than two modules may be integrated into an independent part.

The foregoing descriptions are merely specific embodiments of this application, but are not intended to limit the protection scope of this application. Any variation or replacement readily figured out by persons skilled in the art within the technical scope disclosed in this application shall fall within the protection scope of this application. Therefore, the protection scope of this application shall be subject to the protection scope of the claims.

## Claims

1. A signal latching circuit, comprising a controller, a latch, and a first reset apparatus; **characterized in that**
the controller is electrically connected to both the latch and the first reset apparatus, and the latch is configured to be electrically connected to a switch disposed on a charging path and/or a discharging path;
the controller is configured to transmit a first signal to the latch and transmit a second signal to the first reset apparatus, wherein
the first signal is used to control the switch to turn on, and the second signal is used to indicate that the controller is in a working state;
the first reset apparatus is configured to transmit a first reset signal to the controller in response to not receiving the second signal within a first duration; and
the latch is configured to latch the first signal during a reset period of the controller.

2. The signal latching circuit according to claim 1, **characterized in that** the first reset apparatus is a first watchdog.

3. The signal latching circuit according to claim 1 or 2, further comprising a second reset apparatus; **characterized in that**
the second reset apparatus is electrically connected to both the controller and the latch, and
the second reset apparatus is configured to transmit a second reset signal to the latch to control the switch to turn off in response to not receiving the second signal within a second duration;
the second duration is greater than the first duration.

4. The signal latching circuit according to claim 3, **characterized in that** the second duration is less than a duration threshold;
the duration threshold is configured such that the controller is in an abnormal state after receiving the first reset signal within the duration threshold.

5. The signal latching circuit according to claim 3 or 4, **characterized in that** the second reset apparatus is a second watchdog.

6. A signal latching circuit, comprising: a controller, a latch, and a second reset apparatus, **characterized in that**
the controller is electrically connected to both the latch and the second reset apparatus, the second reset apparatus is further electrically connected to the latch, and the latch is configured to be electrically connected to a switch disposed on a charging path and/or a discharging path;
the controller is configured to transmit a first signal to the latch and transmit a second signal to the second reset apparatus, the first signal being used to control the switch to turn on, and the second signal being used to indicate that the controller is in a working state;
the latch is configured to latch the first signal during a reset period of the controller; and
the second reset apparatus is configured to transmit a second reset signal to the latch to control the switch to turn off in response to not receiving the second signal from the controller within a second duration.

7. A battery management system, comprising a charging switch, a discharging switch, and the signal latching circuit according to any one of claims 1 to 6, **characterized in that**
the latch is electrically connected to the charging switch and/or the discharging switch.

8. The battery management system according to claim 7, further comprising a switch driving circuit, **characterized in that**
the latch is electrically connected to an input terminal of the switch driving circuit, and an output terminal of the switch driving circuit is electrically connected to the charging switch and/or the discharging switch.

9. A battery system, comprising a battery and the battery management system according to claim 7 or 8, **characterized in that**
the battery is electrically connected to the battery management system,
the battery management system being configured to control charging and/or discharging of the battery.

10. An electric device, comprising a load and the battery system according to claim 9, **characterized in that**
the battery system is configured to supply power to the load.

11. A signal latching method applied to the signal latching circuit according to claim 1, **characterized in that** the method comprises:
transmitting, by the first reset apparatus, the first reset signal to the controller in response to not receiving the second signal from the controller within the first duration; and
latching, by the latch, the first signal during the reset period of the controller;
the first signal is used to control the switch to remain on during the reset period of the controller.

12. The method according to claim 11, **characterized in that** the latch signal circuit further comprises: a second reset apparatus, the second reset apparatus is electrically connected to both the controller and the latch, and
the second reset apparatus is configured to transmit a second reset signal to the latch to control the switch to turn off in response to not receiving the second signal within a second duration;
the second duration is greater than the first duration.

13. The method according to claim 12, **characterized in that** the method further comprises:
transmitting, by the second reset apparatus, the second reset signal to the latch in response to not receiving the second signal from the controller within the second duration.

14. The method according to claim 12 or 13, **characterized in that** the reset first apparatus is a first watchdog, the second reset apparatus is a second watchdog.

15. A signal latching method applied to the signal latching circuit according to claim 6, **characterized in that** the method comprises:
transmitting, by the second reset apparatus, the second reset signal to the latch in response to not receiving the second signal from the controller within the second duration; and
clearing, by the latch in response to the second reset signal, the first signal latched by the latch;
the first signal is used to control a switch to remain on during a reset period of the controller.
